# EUROPÄISCHE PATENTSCHRIFT

(11) **EP 0 881 038 B1**
(45) Veröffentlichungstag und Bekanntmachung des Hinweises auf die Patenterteilung: **27.06.2001**
(21) Anmeldenummer: 98108756.2
(22) Anmeldetag: 14.05.1998
(51) Int. Cl.: B24B 37/04, B24B 41/06, B24B 1/00, B24B 7/22, B24B 7/16, H01L 21/304

(54) **Verfahren zur Herstellung einer Halbleiterscheibe**
Method of manufacturing a semiconductor wafer
Procédé de fabrication d'une plaquette semiconductrice

(30) Priorität: 30.05.1997 DE 19722679
(43) Veröffentlichungstag der Anmeldung: 02.12.1998
(73) Patentinhaber: Wacker Siltronic Gesellschaft für Halbleitermaterialien Aktiengesellschaft, 84489 Burghausen (DE)
(72) Erfinder: Huber, Anton, 84489 Burghausen (DE); Drexler, Robert, 84375 Hitzenau (DE)

(56) Entgegenhaltungen:
- EP-A- 0 699 504
- EP-A- 0 751 553
- US-A- 4 239 567
- US-A- 4 597 228

## Beschreibung

Gegenstand der Erfindung ist ein Verfahren zur Herstellung einer Halbleiterscheibe mit geschliffenen Seiten und einer verrundeten Kante.

Die Herstellung einer Halbleiterscheibe umfaßt das Abtrennen der Halbleiterscheibe von einem Kristall und eine Reihe materialabtragender Bearbeitungsschritte. Als Trennwerkzeuge kommen Innenloch-, Band- und Drahtsägen in Betracht. Bei Verwendung einer Drahtsäge können mehrere Halbleiterscheiben gleichzeitig von einem Kristall abgetrennt werden. Drahtgesägte Halbleiterscheiben sind wegen der beim Drahtsägen verwendeten Sägesuspension nach dem Trennvorgang stark verschmutzt. Unabhängig vom eingesetzten Trennverfahren weist eine von einem Kristall abgetrennte Halbleiterscheibe im oberflächennahen Bereich Beschädigungen auf, die durch nachfolgende materialabtragende Bearbeitungsschritte beseitigt werden müssen. Diese Bearbeitungsschritte sind auch notwendig, um die Halbleiterscheibe mit einer verrundeten Kante, einer möglichst glatten Oberfläche und parallelen Seiten zu versehen. Nach dem Trennvorgang entsprechen die Dickenvariation der Halbleiterscheibe, die Ebenheit ihrer Seitenflächen und die Struktur ihrer Kante noch nicht den Erfordernissen, die für die Weiterverarbeitung der Halbleiterscheibe zu elektronischen Bauelementen verlangt werden. Zu den materialabtragenden Bearbeitungsschritten gehören üblicherweise das Kantenverrunden, Läppen, Ätzen und Polieren der abgetrennten Halbleiterscheibe. Gelegentlich wurde auch schon vorgeschlagen, das Läppen, bei dem beide Seiten der Halbleiterscheibe gleichzeitig bearbeitet werden, durch zwei nacheinander durchzuführende Schleifschritte, bei denen jeweils eine Seite der Halbleiterscheibe geschliffen wird, zu ersetzen. In der US-5, 400, 548 ist ein derartiges Schleifverfahren beschrieben. Während des Schleifens liegt die Halbleiterscheibe auf der Auflage eines Scheibenhalters (Chucks). Übliche Scheibenhalter haben eine Auflage aus porösem, keramischen Material. Die Halbleiterscheibe ist durch Vakuumansaugung auf dem Scheibenhalter fixiert. Geschliffen wird die Seite der Halbleiterscheibe, die der auf dem Scheibenhalter liegenden Seite gegenüberliegt. Beim Kantenverrunden wird die Kante der Halbleiterscheibe geschliffen.

Der Oberbegriff der Ansprüche 1 und 7 ist nach diesem Verfahren formuliert.

Durch das Schleifen der Seiten der Halbleiterscheibe läßt sich eine gute Parallelität der Seiten erzielen. Andererseits hat es sich gezeigt, daß die damit erreichbare Ebenheit der Seiten den Anforderungen nicht genügt. Um die gewünschte Ebenheit zu erreichen, müssen nachfolgende materialabtragende Bearbeitungsschritte wie Ätzen und Polieren aufwendiger gestaltet werden. Dementsprechend steigt der für die Herstellung einer Halbleiterscheibe mit gewünschter Scheibenform einzukalkulierende Materialabtrag an, so daß die auf eine bestimmte Kristalllänge bezogene Scheibenausbeute sinkt.

Ein Schleifverfahren, bei dem die erste Seite der Halbleiterscheibe unter anderen Bedingungen geschlitten wird, als die zweite Seite der Halbleiterscheibe, ist bereits in der EP-A-699 504 beschrieben. Demnach muß die Halbleiterscheibe beim Schleifen der ersters Seite auf eine Grundplatte (base plate) mit einem Klelemittel gekleft werden.

Beim Schleifen oder Kantenverrunden einer Halbleiterscheibe muß mit unerwünschten Materialsplitterungen auf der dem Scheibenhalter gegenüberliegenden Seite der Halbleiterscheibe gerechnet werden. In Fachkreisen werden sie Krähenfüße (crow feet) genannt. Eine andere, die Qualität der Halbleiterscheibe beeinträchtigende Erscheinung, betrifft lokale Vertiefungen (dimples) auf den Seiten der Halbleiterscheibe, die beim Schleifen der Seiten erzeugt werden können. Die Gefahr des Auftretens von Krähenfüßen und Vertiefungen ist umso höher, je stärker die zu bearbeitende Halbleiterscheibe mit Partikeln verschmutzt ist. Besonders drahtgesägte Halbleiterscheiben müssen daher vor dem Schleifen oder Kantenverrunden aufwendig gereinigt werden.

Es bestand daher die Aufgabe, zu erreichen, daß eine Halbleiterscheibe, auch wenn sie nur grob gereinigt und ihre Oberfläche noch mit Partikeln erheblich verunreinigt ist, geschliffen und kantenverrundet werden kann, ohne daß mit den vorstehend beschriebenen Schwierigkeiten gerechnet werden muß.

Gegenstand der Erfindung ist ein Verfahren gemäß Anspruch 1, sowie ein Verfahren gemäß Anspruch 7.

Das Material, aus dem die Auflage des Scheibenhalters gefertigt ist, not vorzugsweise einen organischen Charakter und ist weicher als das steife keramische Material. Das Material muß weich genug sein, damit Partikel, die sich zwischen der Halbleiterscheibe und dem Scheibenhalter befinden, durch die beim Fixieren der Halbleiterscheibe ausgeübte Druckkraft in die Auflage des Scheibenhalters eingebettet werden. Außerdem muß das Material weich genug sein, damit nicht die Halbleiterscheibe, sondern die Auflage elastisch verformt wird, wenn die Halbleiterscheibe mit einer unebenen Seite auf die Oberfläche der Auflage gelegt und auf dem Scheibenhalter fixiert wird. Das Material der Auflage not eine Shore-A Härte von 5 bis 92. Weiterhin ist bevorzugt, daß die Auflage vor der Verwendung des Scheibenhalters überschliffen und ihr dadurch eine möglichtst ebene Oberfläche gegeben werden kann. Die Auflage des Scheibenhalters besteht bevorzugt aus einem elastischen organischen Material mit Porenstruktur. Besonders bevorzugt ist ein Material, wie beispielsweise Polyurethan. Die Auflage kann auf den Scheibenhalter beispielsweise gespannt oder geklebt sein. Wenn die Halbleiterscheibe über eine Vakuumansaugung auf dem Scheibenhalter fixiert wird, ist es zweckmäßig, die Auflage zuvor mit Saugkanälen zu versehen, beispielsweise indem sie an mehreren Stellen gelocht wird.

Gegenstand der Erfindung ist ein Verfahren, bei dem der Scheibenhalter eingesetzt wird. Das Verfahren ist dadurch gekennzeichnet, daß die Halbleiterscheibe beim Schleifen der ersten Seite auf einem Scheibenhalter mit einer weichen Auflage fixiert ist und beim Schleifen der zweiten Seite auf einem Scheibenhalter mit einer harten Auflage fixiert ist.

Eine Auflage wird im Zusammenhang mit der Erfindung als hart bezeichnet, wenn eine Halbleiterscheibe, die mit einer unebenen Seite auf der Oberfläche der Auflage liegt, beim Fixieren auf dem Scheibenhalter elastisch verformt wird. Diese Auflagen bestehen aus anorganischem, insbesondere keramischem Material. Die Shore A-Härte eines solchen Materials liegt über 99,5.

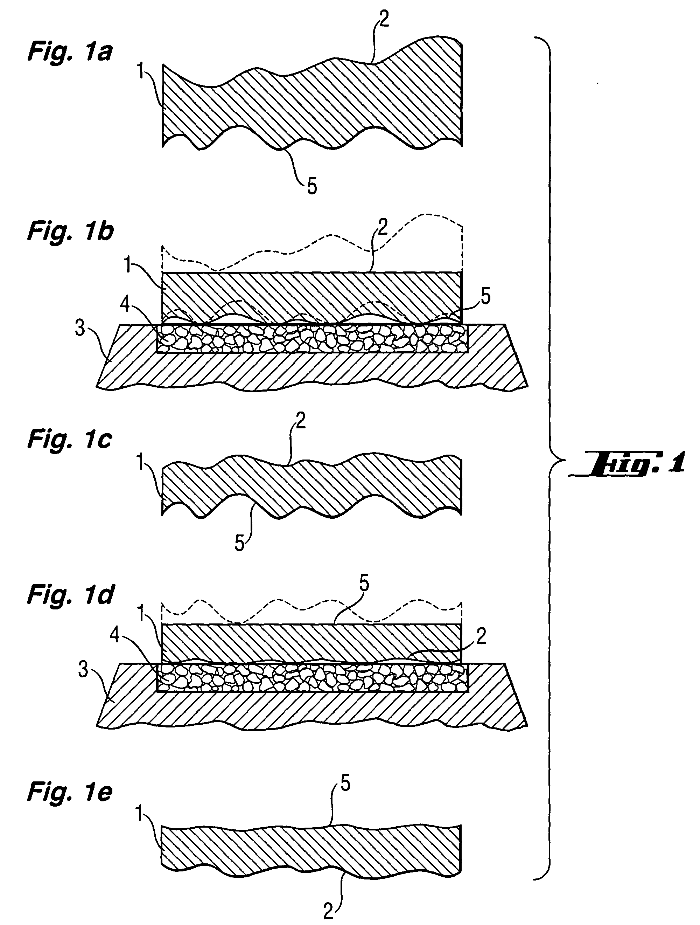

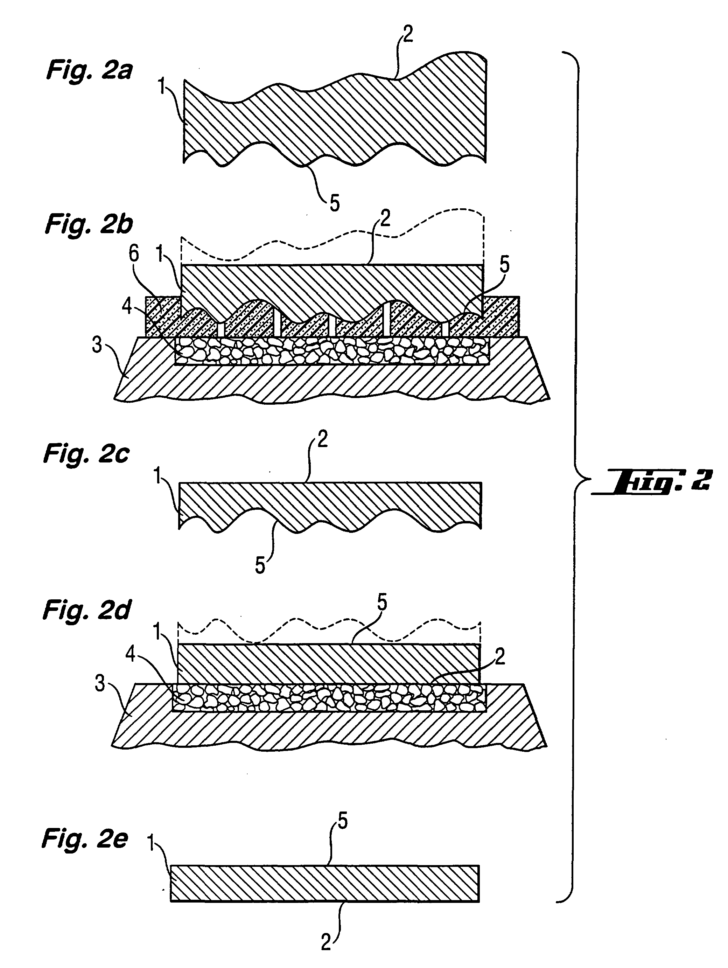

Die Erfindung und ihre Vorteile werden nachfolgend an Hand von Figuren näher erläutert. Figur 1 zeigt schematisch die Vorgänge beim Schleifen der Seiten einer Halbleiterscheibe bei Verwendung eines üblichen Scheibenhalters mit harter Auflage. Figur 2 zeigt eine entsprechende Darstellung der Vorgänge beim Schleifen der Halbleiterscheibe gemäß der Erfindung.

Zunächst wird auf Figur 1 Bezug genommen. Die dargestellten Vorgänge beim Schleifen der Seiten einer Halbleiterscheibe stellen eine Beschreibung des Stands der Technik dar. Wie der Figur la zu entnehmen ist, hat eine Halbleiterscheibe 1, die von einem Kristall abgetrennt worden ist, weder ebene noch parallele Seiten. Die Seiten haben ein welliges Profil und die Scheibendicke variiert entlang des Scheibendurchmessers. Nachfolgend wird eine Seite der Halbleiterscheibe als Vorderseite 2 und die ihr gegenüberliegende Seite als Rückseite 5 bezeichnet. Wenn die Halbleiterscheibe 1 auf die harte Auflage 4 eines Scheibenaufnehmers 3 gelegt und beispielsweise durch Vakuumansaugung darauf fixiert wird (Figur 1b), wird die Halbleiterscheibe mit der unebenen Rückseite 5 gegen die Auflage 4 gepreßt. Die Halbleiterscheibe wird dabei elastisch verformt und schmiegt sich an die Oberfläche der Auflage an. Wellige Unebenheiten der Rückseite werden teilweise ausgeglichen und teilweise in der Amplitude verringert. Ein Partikel, der sich zwischen der Auflage und der Halbleiterscheibe befindet, verformt die Scheibe, wodurch die Amplitude der Welligkeit auf der dem Partikel gegenüberliegenden Vorderseite der Halbleiterscheibe lokal erhöht ist. Überschreitet die vom Partikel ausgehende Druckkraft einen bestimmten Wert, bricht Material an dieser Stelle aus und es entsteht ein Krähenfuß. Diese Situation kann sowohl beim Schleifen der Seiten der Halbleiterscheibe, als auch beim Verrunden der Kante der Halbleiterscheibe auftreten.

Das Schleifen der Vorderseite der Halbleiterscheibe erzeugt zwar zunächst eine ebene Seite. Diese wird jedoch wieder wellig, sobald die Fixierung der Halbleiterscheibe aufgehoben wird und die elastisch verformte Halbleiterscheibe 1 sich entspannen kann (Figur 1c). Im folgenden Schleifschritt wird die Rückseite 5 der Halbleiterscheibe geschliffen, wobei die Halbleiterscheibe mit der Vorderseite 2 auf der harten Auflage 4 des Scheibenhalters 3 fixiert ist. Die Welligkeit der Vorderseite wird durch den ersten Schleifschritt zwar verringert, jedoch nicht vollständig beseitigt. Die Halbleiterscheibe wird deshalb wieder elastisch verformt, sobald sie mit der Vorderseite 2 auf der Auflage 4 des Scheibenhalters 3 fixiert ist (Figur 1d). Wird nach dem Schleifen der Rückseite die Fixierung der Halbleiterscheibe aufgehoben, erhält man eine Halbleiterscheibe 1, deren Seiten bereits die angestrebte Parallelität aufweisen, jedoch noch eine unerwünscht hohe Restwelligkeit besitzen (Figur 1e).
Falls sich beim Schleifen der Halbleiterscheibe ein Partikel zwischen der Halbleiterscheibe und dem Scheibenhalter befindet, durch den die Halbleiterscheibe lokal verformt wird, wird an dieser Stelle zuviel Material abgeschliffen und eine Vertiefung (dimple) auf der Seite der Halbleiterscheibe erzeugt (nicht dargestellt).

Das erfindungsgemäße Verfahren sieht vor, die Halbleiterscheibe zum Schleifen der ersten Seite, die nachfolgend Vorderseite genannt wird, auf einen Scheibenhalter mit einer weichen Auflage zu fixieren. Dies ist in Figur 2 dargestellt. Die Seiten der von einem Kristall abgetrennten Halbleiterscheibe 1 sind nicht eben und liegen nicht parallel zueinander (Fig. 2a). Die Halbleiterscheibe kann durchaus mit Partikeln behaftet sein, ohne daß beim Schleifen oder Kantenverrunden Krähenfüße und Vertiefungen erzeugt werden. Selbst stark verschmutzte, drahtgesägte Halbleiterscheiben brauchen vor dem Schleifen nur grob gereinigt zu werden. Es ist ausreichend, die Sägesuspension in dem Maß abzuspülen, daß ihre flüssigen Bestandteile dabei entfernt werden. Partikel, die sich auch nach der Scheibenreinigung zwischen der Halbleiterscheibe und der Auflage befinden, werden beim Fixieren der Halbleiterscheibe 1 auf den Scheibenhalter 3 in die weiche Auflage 6 gedrückt, ohne die Halbleiterscheibe zu verformen. Die Unebenheiten auf der Rückseite 5 der Halbleiterscheibe werden beim Schleifen der Vorderseite 2 ebenfalls von der Auflage aufgenommen (Fig. 2b).

Die weiche Auflage ist beispielsweise auf einen herkömmlichen Scheibenhalter geklebt oder über diesen gespannt. Es kann auch ein herkömmlicher Scheibenhalter verwendet werden, bei dem die harte Auflage durch eine weiche Auflage ersetzt ist. Bevorzugt ist, daß die weiche Auflage auf dem Scheibenhalter wenigstens einmal eben überschliffen wird, bevor der Scheibenhalter für die Bearbeitung von Halbleiterscheiben verwendet wird. Zweckmäßig ist auch, die weiche Auflage nach jeder Scheibenbearbeitung, beispielsweise mit einer Bürste, von Partikeln zu reinigen. Bevorzugt ist ferner eine Reinigung der geschliffenen Vorderseite, die in der Schleifmaschine bei auf dem Scheibenhalter liegender Halbleiterscheibe vorgenommen werden kann und der Entfernung von Partikeln dient.

Die auf dem Scheibenhalter fixierte Halbleiterscheibe ist nicht elastisch verformt, so daß durch den ersten Schleifschritt eine ebene Vorderseite resultiert, die auch nach dem Abnehmen der Halbleiterscheibe 1 vom Scheibenhalter erhalten bleibt (Fig. 2c). Die Erfindung sieht weiter vor, beim Schleifen der Rückseite 5 der Halbleiterscheibe einen Scheibenaufnehmer 3 mit harter Auflage 4 einzusetzen. Die einseitig geschliffene Halbleiterscheibe wird zu diesem Zweck umgedreht, und mit der bereits eben geschliffenen Vorderseite 2 auf dem Scheibenhalter 3 fixiert. Da die Vorderseite eine ebene Referenzfläche darstellt, wird die Halbleiterscheibe bei diesem Vorgang nicht mehr elastisch verformt. Durch die Verwendung eines Scheibenhalters 3 mit harter Auflage 4 kann die Rückseite 5 der Halbleiterscheibe mit hoher Präzision parallel zu dieser Referenzfläche geschliffen werden (Fig. 2d). Der dabei erzeugte Abrieb kann in der Schleifmaschine und noch während die Halbleiterscheibe auf dem Scheibenhalter liegt, abgespült werden. Die Halbleiterscheibe 1 behält ihre eben und parallel geschliffenen Seiten auch nach dem Entfernen vom Scheibenhalter bei (Fig. 2e).

Die Kante der Halbleiterscheibe kann vor oder nach dem Schleifen der Seiten verrundet werden. Falls die Kante vor dem Schleifen der Seiten verrundet wird, und somit noch Verschmutzungen vom Sägen aufweist, muß die Halbleiterscheibe auf einem Scheibenhalter mit weicher Auflage fixiert werden, um das Entstehen von Krähenfüßen zu vermeiden. Andererseits ist bevorzugt, daß eine Halbleiterscheibe, deren Seiten bereits geschliffen und sauber sind, zum Verrunden der Kante auf einem Scheibenhalter mit harter Auflage fixiert wird.

Gemäß Anspruch 7 kann auch das Schleifen einer Seite einer Halbleiterscheibe in zwei Schritten, bei denen zwei verschiedene Schleifwerkzeuge eingesetzt werden, erfolgen (Zwei-Spindel-Schleifverfahren). Der erste Schritt umfaßt ein Grob- und der zweite Schritt ein Feinschleifen der Seite. Um auch für dieses Verfahren die Erfindung nutzen zu können, wird vorgeschlagen, beide Seiten der Halbleiterscheibe erst grobzuschleifen und anschließend feinzuschleifen. Beim Grobschleifen der Seiten ist die Halbleiterscheibe auf einem Scheibenhalter mit weicher Auflage zu fixieren. Beim Feinschleifen der Seiten sollte die Halbleiterscheibe auf einen Scheibenhalter mit harter Auflage fixiert werden.

Eine Halbleiterscheibe, deren Kante und Seiten erfindungsgemäß bearbeitet wurden, wird anschließend einer weiteren materialabtragenden und ihre Oberfläche glättenden Behandlung unterzogen. Diese kann darin bestehen, daß die Halbleiterscheibe geätzt und poliert wird, wobei gegebenenfalls auf den Ätzschritt verzichtet werden kann. Der Polierschritt kann eine Einseitenpolitur beider oder nur einer Seite der Halbleiterscheibe oder eine Doppelseitenpolitur umfassen.

### Beispiel:

Die Wirksamkeit des Verfahrens wurde an Siliciumscheiben mit 200 mm Durchmesser getestet. Hierbei wurde folgende Fertigungsabfolge gewählt: Drahtsägen - Grobreinigung - Schleifen der Vorderseite (Scheibenhalter mit weicher Auflage) - Reinigung der Vorderseite in der Schleifmaschine - Schleifen der Rückseite (Scheibenhalter mit harter Auflage) - Reinigung der Rückseite in der Schleifmaschine - Kantenverrunden (Scheibenhalter mit harter Auflage)

Zum Vergleich wurden Scheiben mit gleicher Fertigungsabfolge, aber mit Schleifen der Vorderseite auf einem Scheibenhalter mit harter Auflage, gefertigt. Nach einer Weiterbehandlung durch Ätzen und Doppelseitenpolieren aller Siliciumscheiben wurden optische Untersuchungen mit einem "Magic Mirror" durchgeführt. Die Untersuchungen zeigten, daß die beim Sägen entstandenen Unebenheiten deutlich besser reduziert werden konnten, wenn die Halbleiterscheiben erfindungsgemäß behandelt wurden. Die Untersuchung zeigte auch, daß sich anhaftende Partikel bei einer erfindungsgemäßen Behandlung der Halbleiterscheiben nicht negativ auf das Behandlungsergebnis auswirkten, obwohl die nur grobgereinigten Halbleiterscheiben mit Partikeln erheblich verunreinigt waren.

## Patentansprüche

1. Verfahren zur Herstellung einer Halbleiterscheibe, die zwei eben geschliffene Seiten und eine verrundete Kante aufweist, durch Abtrennen der Halbleiterscheibe von einem Einkristall und durch Schleifen der Seiten und der Kante der Halbleiterscheibe, wobei die Halbleiterscheibe auf einer Auflage eines Scheibenhalters fixiert ist, dadurch gekennzeichnet, daß die Halbleiterscheibe beim Schleifen der ersten Seite auf einem Scheibenhalter mit einer weichen Auflage mit einer Shore-A Härte von 5 bis 92 fixiert ist und beim Schleifen der zweiten Seite auf einem Scheibenhalter mit einer harten Auflage mit einer Shore-A Härte von über 99,5 fixiert ist, wobei die Halbleiterscheibe in einem Zustand auf die weiche Auflage gelegt wird, in dem sie mit Partikeln erheblich verunreinigt ist.

2. Verfahren nach Anspruch 1, dadurch gekennzeichnet, daß nach dem Abtrennen der Halbleiterscheibe vom Kristall zuerst die Kante der Halbleiterscheibe verrundet wird, und dabei die Halbleiterscheibe auf einem Scheibenhalter mit weicher Auflage fixiert ist.

3. Verfahren nach Anspruch 1, dadurch gekennzeichnet, daß nach dem Abtrennen der Halbleiterscheibe vom Kristall zuerst die Seiten der Halbleiterscheibe geschliffen werden und anschließend die Kante der Halbleiterscheibe verrundet wird, und die Halbleiterscheibe beim Verrunden der Kante auf einem Scheibenhalter mit harter Auflage fixiert ist.

4. Verfahren nach einem der Ansprüche 1 bis 3, dadurch gekennzeichnet, daß die Halbleiterscheibe nach dem Abtrennen vom Kristall grob gereinigt wird.

5. Verfahren nach einem der Ansprüche 1 bis 4, dadurch gekennzeichnet, daß die Halbleiterscheibe im Anschluß an das Schleifen der Seiten und das Verrunden der Kante geätzt und poliert wird.

6. Verfahren nach einem der Ansprüche 1 bis 5, dadurch gekennzeichnet, daß die Halbleiterscheibe im Anschluß an das Schleifen der Seiten und das Verrunden der Kante poliert wird.

7. Verfahren zur Herstellung einer Halbleiterscheibe, die zwei eben geschliffene Seiten und eine verrundete Kante aufweist, durch Abtrennen der Halbleiterscheibe von einem Einkristall und durch Schleifen der Seiten und der Kante der Halbleiterscheibe, wobei die Halbleiterscheibe auf einer Auflage eines Scheibenhalters fixiert ist, und das Schleifen der Seiten ein Grob- und ein Feinschleifen umfaßt, dadurch gekennzeichnet, daß die Halbleiterscheibe beim Grobschleifen der Seiten auf einem Scheibenhalter mit einer weichen Auflage mit einer Shore-A Harte von 5 bis 92 fixiert ist und beim Feinschleifen der Seiten auf einem Scheibenhalter mit einer harten Auflage mit einer Shore-A Harte von über 99,5 fixiert ist.

8. Verfahren nach Anspruch 1 oder 7, dadurch gekennzeichnet, daß die weiche Auflage eine Shore-A Härte von 50 bis 90 besitzt.

9. Verfahren nach Anspruch 1 oder Anspruch 7, dadurch gekennzeichnet, daß die weiche Auflage aus Polyurethan besteht.

10. Verfahren nach Anspruch 1 oder 7, dadurch gekennzeichnet, daß die weiche Auflage mindestens einmal eben überschliffen wird.

## Claims

1. Method of producing a semiconductor wafer having two flat-ground sides and a rounded edge by cutting the semiconductor wafer from a single crystal and by grinding the sides and the edge of the semiconductor wafer, the semiconductor wafer being fixed on a support of a wafer holder, characterized in that the semiconductor wafer is fixed on a wafer holder having a soft support having a Shore A hardness of 5 to 92 during grinding of the first side and is fixed on a wafer holder having a hard support having a Shore A hardness of above 99.5 during grinding of the second side, the semiconductor wafer being placed on the soft support in a state in which it is considerably contaminated with particles.

2. Method according to Claim 1, characterized in that, after cutting the semiconductor wafer from the crystal, the edge of the semiconductor wafer is first rounded and, during this operation, the semiconductor wafer is fixed on a wafer holder having a soft support.

3. Method according to Claim 1, characterized in that, after cutting the semiconductor wafer from the crystal, the sides of the semiconductor wafer are first ground and then the edge of the semiconductor wafer is rounded, and during rounding of the edge, the semiconductor wafer is fixed on a wafer holder having a hard support.

4. Method according to any of Claims 1 to 3, characterized in that the semiconductor wafer is crudely cleaned after cutting from the crystal.

5. Method according to any of Claims 1 to 4, characterized in that the semiconductor wafer is etched and polished following the grinding of the sides and the rounding of the edge.

6. Method according to any of Claims 1 to 5, characterized in that the semiconductor wafer is polished following the grinding of the sides and the rounding of the edge.

7. Method for producing a semiconductor wafer which has two flat-ground sides and a rounded edge by cutting the semiconductor wafer from a single crystal and by grinding the sides and the edge of the semiconductor wafer, the semiconductor wafer being fixed on a support of a wafer holder, and the grinding of the sides comprising a coarse grinding and a fine grinding, characterized in that the semiconductor wafer is fixed on a wafer holder having a soft support having a Shore A hardness of 5 to 92 during the coarse grinding of the sides and is fixed on a wafer holder having a hard support having a Shore A hardness of above 99.5 during the fine grinding of the sides.

8. Method according to Claim 1 or 7, characterized in that the soft support has a Shore A harndess of 50 to 90.

9. Method according to Claim 1 or Claim 7, characterized in that the soft support is composed of polyurethane.

10. Method according to Claim 1 or 7, characterized in that the soft support is surface-ground flat at least once.

## Revendications

1. Procédé de fabrication d'une plaquette semi-conductrice, qui présente deux côtés meulés à plat et un bord arrondi, par détachement de la plaquette semi-conductrice d'un monocristal et par meulage des côtés et du bord de la plaquette semi-conductrice, la plaquette semi-conductrice étant fixée sur un support d'un porteur de plaquette, caractérisé en ce que la plaquette semi-conductrice lors du meulage du premier côté, est fixée sur un porteur de plaquette avec un support mou de dureté Shore A de 5 à 92, et lors du meulage du deuxième côté, est fixée sur un porteur de plaquette avec un support dur de dureté Shore A de plus de 99,5, la plaquette semi-conductrice étant placée dans un état sur le support mou dans lequel elle est considérablement contaminée par des particules.

2. Procédé selon la revendication 1, caractérisé en ce qu'après avoir détaché la plaquette semi-conductrice du cristal, tout d'abord le bord de la plaquette semi-conductrice est arrondi, et à cette occasion, la plaquette semi-conductrice est fixée sur un porteur de plaquette avec un support mou.

3. Procédé selon la revendication 1, caractérisé en ce qu'après avoir détaché la plaquette semi-conductrice du cristal, tout d'abord les côtés de la plaquette semi-conductrice sont meulés et ensuite le bord de la plaquette semi-conductrice est arrondi, et la plaquette semi-conductrice est fixée lors de l'arrondissement du bord sur un porteur de plaquette avec un support dur.

4. Procédé selon l'une quelconque des revendications 1 à 3, caractérisé en ce que la plaquette semi-conductrice est grossièrement nettoyée après la séparation du cristal.

5. Procédé selon l'une quelconque des revendications 1 à 4, caractérisé en ce que la plaquette semi-conductrice est gravée et polie après le meulage des côtés et l'arrondissement du bord.

6. Procédé selon l'une quelconque des revendications 1 à 5, caractérisé en ce que la plaquette semi-conductrice est polie après le meulage des côtés et l'arrondissement du bord.

7. Procédé de fabrication d'une plaquette semi-conductrice, qui présente deux côtés meulés à plat et un bord arrondi, par détachement de la plaquette semi-conductrice d'un monocristal et par meulage des côtés et du bord de la plaquette semi-conductrice, la plaquette semi-conductrice étant fixée sur un support d'un porteur de plaquette, et le meulage des côtés comprenant un meulage grossier et un meulage fin, caractérisé en ce que la plaquette semi-conductrice, lors du meulage grossier des côtés, est fixée sur un porteur de plaquette avec un support mou de dureté Shore A de 5 à 92, et lors du meulage fin des côtés, est fixée sur un porteur de plaquette avec un support dur de dureté Shore A de plus de 99,5.

8. Procédé selon la revendication 1 ou 7, caractérisé en ce que le support mou présente une dureté Shore A de 50 à 90.

9. Procédé selon la revendication 1 ou la revendication 7, caractérisé en ce que le support mou se compose de polyuréthane.

10. Procédé selon la revendication 1 ou 7, caractérisé en ce que le support mou est meulé à plat au moins une fois.
